Europäisches Patentamt

European Patent Office

Office européen des brevets

(19)

(11) EP 1 161 986 A2

(12) **EUROPEAN PATENT APPLICATION**

(43) Date of publication:
**12.12.2001 Bulletin 2001/50**

(51) Int Cl.⁷: **B01J 19/00**, C01B 13/32, C01G 3/02, C30B 23/02, C30B 29/22

(21) Application number: **01113525.8**

(22) Date of filing: **05.11.1999**

(84) Designated Contracting States:
**AT BE CH CY DE DK ES FI FR GB GR IE IT LI LU MC NL PT SE**

(30) Priority: **17.02.1999 US 120720 P**
**27.09.1999 US 156264 P**

(62) Document number(s) of the earlier application(s) in accordance with Art. 76 EPC:
**99973699.4 / 1 077 764**

(71) Applicant: **Oxxel Oxide Electronics Technology, Inc.**
**Palo Alto, CA 94306 (US)**

(72) Inventor: **Bozovic, Ivan**
**Palo Alto, California 94303 (US)**

(74) Representative: **Weber-Bruls, Dorothée, Dr.**
**Forrester & Boehmert,**
**Pettenkoferstrasse 20-22**
**80336 München (DE)**

Remarks:
This application was filed on 12 - 06 - 2001 as a divisional application to the application mentioned under INID code 62.

(54) **Apparatus for combinatorial molecular beam epitaxy**

(57) Apparatus for combinatorial molecular beam epitaxy comprising:

- a vacuum chamber,

- a substrate holder for holding a substrate inside said vacuum chamber having a substrate surface bounded by two or more pairs of opposite side regions and defining a plurality of surface regions at known position with respect to said side regions,

- a gaseous source of oxygen atoms and

- a plurality of elemental metal sources with source shutters contained in said vacuum chamber,

further comprising at least one device being selected from the group consisting of:

- a heater system for heating said substrate so as to produce a temperature gradient on progressing between one side region and another in a pair of opposite side regions of said substrate,

- a system for applying said oxygen atoms to said substrate to achieve a gradient of the partial pressure of said source of oxygen atoms and the substrate surface regions,

- a sieve mask in front of each elemental metal source effective to produce a desired gradient of atomic flux through said sieve mask on progressing between one side region and another in a pair of opposite side regions of the substrate or effective to produce a uniform atomic flux through said sieve mask and

- a movable substrate-shadowing shutter placed between each elemental metal source and the target placeable at a plurality of selected positions.

| | C | | | | |
|---|---|---|---|---|---|
| $A_1B_0C_0D_0O_3$ | $A_{0.8}B_{0.2}C_1D_0O_3$ | $A_{0.8}B_{0.4}C_1D_0O_3$ | $A_{0.4}B_{0.6}C_1D_0O_3$ | $A_{0.2}B_{0.8}C_1D_0O_3$ | $A_0B_1C_1D_0O_3$ |
| $A_1B_0C_{0.8}D_{0.2}O_3$ | $A_{0.8}B_{0.2}C_{0.8}D_{0.2}O_3$ | $A_{0.6}B_{0.4}C_{0.8}D_{0.2}O_3$ | $A_{0.4}B_{0.6}C_{0.8}D_{0.2}O_3$ | $A_{0.2}B_{0.8}C_{0.8}D_{0.2}O_3$ | $A_0B_1C_{0.8}D_{0.2}O_3$ |
| $A_1B_0C_{0.6}D_{0.4}O_3$ | $A_{0.8}B_{0.2}C_{0.6}D_{0.4}O_3$ | $A_{0.6}B_{0.4}C_{0.6}D_{0.4}O_3$ | $A_{0.4}B_{0.6}C_{0.6}D_{0.4}O_3$ | $A_{0.2}B_{0.8}C_{0.6}D_{0.4}O_3$ | $A_0B_1C_{0.6}D_{0.4}O_3$ |
| $A_1B_0C_{0.4}D_{0.6}O_3$ | $A_{0.8}B_{0.2}C_{0.4}D_{0.6}O_3$ | $A_{0.6}B_{0.4}C_{0.4}D_{0.6}O_3$ | $A_{0.4}B_{0.6}C_{0.4}D_{0.6}O_3$ | $A_{0.2}B_{0.8}C_{0.4}D_{0.6}O_3$ | $A_0B_1C_{0.4}D_{0.6}O_3$ |
| $A_1B_0C_{0.2}D_{0.8}O_3$ | $A_{0.8}B_{0.2}C_{0.2}D_{0.8}O_3$ | $A_{0.6}B_{0.4}C_{0.2}D_{0.8}O_3$ | $A_{0.4}B_{0.6}C_{0.2}D_{0.8}O_3$ | $A_{0.2}B_{0.8}C_{0.2}D_{0.8}O_3$ | $A_0B_1C_{0.2}D_{0.8}O_3$ |
| $A_1B_0C_0D_1$ | $A_{0.8}B_{0.2}C_0D_1O_3$ | $A_{0.6}B_{0.4}C_0D_1O_3$ | $A_{0.42}B_{0.6}C_0D_1O_3$ | $A_{0.2}B_{0.8}C_0D_1O_3$ | $A_0B_1C_0D_1O_3$ |

A — B — D

11 — 12

Fig. 1

## Description

Field of the invention

The present invention relates to an apparatus for synthesis and identification of complex metal oxides formed as combinatorial variation by molecular beam epitaxy on a substrate, and to the result of such synthesis, i.e., combinatorial arrays of samples comprised of stable or metastable complex oxides, multilayers, and superlattices. Various aspects of the synthesis process may be carried out by a program-controlled processor.

## Documents

[1] Ivan Bozovic, *et al.*, *Physica* C $\underline{235\text{-}240}$:178-181 (1994).

[2] X.D. Xiang, *et al.*, *Science* $\underline{268}$:1738-1740 (1995).

[3] Gabriel Briceno, *et al.*, *Science* $\underline{270}$:273-275 (1995).

[4] Earl Danielson, *et al.*, *Nature* $\underline{389}$:944-948 (1997).

[5] Earl Danielson, *et al.*, *Science* $\underline{279}$:837-839 (1998).

[6] Ivan Bozovic, *et al.*, *J. Superconductivity* $\underline{7}$: 187-195 (1994).

[7] Ivan Bozovic and J.N. Eckstein, *Applied Surface Science* $\underline{113\text{-}114}$:189-197 (1997).

[8] Ivan Bozovic, et al., "Reflection High-Energy Electron Diffraction as a Tool for Real Time-Characterization of Growth of Complex Oxides," Chapter 3 in CHARACTERIZATION OF THIN FILM GROWTH PROCESSES VIA IN SITU TECHNIQUES, A. Kraus and O. Auciello, editors (John Wiley and Sons, New York, 1999) in press.

[9] C.J. Kraisinger and D.G. Schlom, *J. Vacuum Science and Technology* (1998) in press.

[10] M.E. Klausmeier-Brown, et al., *Applied Physics Letters* $\underline{60}$:657-659 (1992).

[11] E. Bauer, *Report of Progress in Physics* $\underline{57}$: 895-938 (1994).

[12] M.S. Altman, et al., *Surface Rev. and Lett.* $\underline{5}$: 1129-1141 (1998).

[13] A.R. Kraus, et al., *Materials Research Society Bulletin* $\underline{20}$(5):18-23 (1995).

## Background of the Invention

Complex (ternary, quaternary, etc.) oxides have been the subject of increased interest of the scientific and technological community. These include compounds which are high-temperature superconductors such as $La_{2-x}Sr_xCuO_4$, $YBa_2Cu_3O_{7-x}$ or $Bi_{2-x}Pb_xSr_2Ca_{n-1}Cu_nO_{2n+4+y}$, etc., others that are ferroelectrics like $Pb_{1-x-y}La_xZr_yTiO_3$ or $Ba_{1-x}Sr_xTiO_3$, ferromagnets that show the so-called colossal magnetoresistance like $La_{1-x-y}Sr_xCa_yMnO_3$, and many other oxides with a variety of other functionalities, such as pyroelectricity, piezoelectricity, photo-conductivity, and luminescence [1].

It is clear from the few formulae cited above that the number of conceivable compounds is huge already for ternary oxides, because of large number of possible stoichiometric ratios. Indeed, the complexity increases exponentially with the number of elements combined. To understand the enormity of the problem (and the reason why nothing is known about such compounds), imagine that it is desired to explore compounds involving ten given elements, i.e. compounds with the generic formula $(A_1)_{x1}(A_2)_{x2}.....(A_{10})_{x10}O_y$. To be specific consider the phases distinct if they differ by say 0.01 or more in the index of at least one element. Under these assumptions, there would be more than $10^{16}$ different compositions to try.

Traditional approach in search for new inorganic materials has been to mix predetermined quantities of some starting elements or compounds, make them react, and perform some characterization measurements to determine the structure or some physical property of the sample. With this feedback, one can proceed to synthesize another sample of a different composition, and so on. In general, such sequential search is slow and clearly inadequate when dealing with more complex compounds, unless one has a very strong intuition where to look.

For a faster and more systematic search, one would like to employ some parallel processing, i.e., synthesize a batch of many (100, 1,000 or even more) samples at once, with a systematic and known stoichiometry variation across the series, ideally, one would also like to test the samples in parallel, i.e., all at once. If the samples are coded somehow, in a one- or two-dimensional matrix, one would be able to tell which composition provides the optimum value of the property under study.

This idea, known as combinatorial search for new materials, or combinatorial chemistry, has actually been utilized extensively and with great success in pharmaceutical research, for quite some time. More recently, it has been implemented also in inorganic chemistry, and more specifically, in search for novel complex oxides, as follows. [2, 3].

An array of say 10x10 substrates is exposed to several atomic or molecular beams coming from sputtering sources. (Alternatively, one can use a single large-area substrate and cut it subsequently.) Masks are used to selectively block one or other of the substrates, so that different quantities of a given component are deposited onto different substrates. Once this is finished, all the samples are heated to make the components react. This technique has been used with success to discover new phosphors, of various colors and more efficient than the ones currently used in cathode-ray tubes. [4, 5]. Note that this particular physical property is rather amenable to parallel testing--one simply illuminates the sample array with ultraviolet light and observes which particular sample shines the most.

One drawback of this method is that in this way only thermodynamically stable compounds can be formed, and most of the samples end up being (generally useless) multiphase mixtures. And even the single-phase ones are polycrystalline, which complicates determination of their intrinsic material properties.

ALL-MBE (atomic layer-by-layer molecular beam epitaxy) is a technique developed in the last decade for deposition of single-crystal thin films of cuprate superconductors and other complex oxides. [1, 6, 7]. An ALL-MBE system consists of an ultra-high vacuum chamber equipped with a number of thermal effusion sources (Knudsen cells) with computer-controlled shutters. To monitor the atomic fluxes, atomic absorption spectroscopy has been proved the most useful, since this is accurate enough to detect changes of less than one per cent and fast enough to allow real-time-feedback control. By using a pure ozone beam, sufficient oxidation can be achieved under high vacuum conditions, which permits in-situ monitoring of the surface structure by RHEED (reflection high-energy electron diffraction) and other surface analytical tools. [8].

Thin, films grown by ALL-MBE typically show atomically flat surfaces and, in the case of superlattices and multi-layers, virtually perfect interfaces. Next, surfaces and interfaces can be controlled. For example, the surface layer of an as-grown or cleaved $Bi_2Sr_2CaCu_2O_{8+x}$ single crystal is most likely to be a Bi-O layer - this is a natural termination plane as well as the easiest cleavage plane. Layer-by-layer growth, however, can be terminated at any desired atomic monolayer, e.g., at a $CuO_2$ plane. If one wants to switch to another compound at that point, the starting plane can again be selected at will. This provides great flexibility in tailoring surfaces and interfaces, as long as surface reconstruction can be avoided, and opens new avenues in fabrication of devices such as tri-layer (or "sandwich") junctions, for example. Traditionally, the barrier layer is inserted between the two naturally terminated layers of the host material (the bottom and the top electrode); here, it is possible to insert a layer of a foreign compound in-between two "inner" planes of a host compound which are not natural termination planes.

Next, layer-bay-layer growth makes it easy to deposit a fraction of a mono-layer of a given atomic species and then complete the mono-layer with another element. In this way, if there is no bulk diffusion, one can select at will the mono-layers to be doped. The dopant may be picked to have a different valence, which enables one to modify and control the local charge carrier density. Modulation doping has been accomplished in this manner. [7]

Next, in complex compounds one frequently finds several energetically degenerate or nearly degenerate phases; a familiar example is provided by 2201, 2212, 2223, 2234, etc. phases in the $Bi_2Sr_2Ca_{n-1}Cu_nO_{2n+4+x}$ family. In general, by cooling the melt one obtains a mixture of these phases, for entropy reasons. Layer-by-layer growth, however, enables one to discriminate among such phases, i.e., to selectively grow the desired one only. Unless the temperature is raised, the topological barrier will protect the phase grown, since phase separation would require extensive bulk diffusion. In this way, it has been possible to assemble metastable compounds such as $Bi_2Sr_2Ca_{n-1}Cu_nO_{2n+4+x}$ and $BiSr_2Ca_{n-1}Cu_nO_{2n+3+x}$ with n up to 10; these were the first truly 'artificial' high-$T_c$ materials. [1, 6]

Summary of the Invention

The apparatus according to claim 1 can be used for producing a position-addressable combinatorial library of complex oxides having thermally stable or metastable structures. The library is formed on a substrate having a substrate surface bounded by two or more pairs of opposite side regions, and defining a plurality of surface regions at known position with respect to the side regions. Formed on these regions are thermally stable or metastable oxides having the formulae $(A_1)_{x1}(A_2)_{x2}...(A_n)_{xn}O_y$, where at least one of the elemental components $A_i$ is a metal, $x_i$, y are whole or fractional numbers including zero, i=1,2,...n, where n=2-20, and the stoichiometries or structures of the oxides vary systematically and in a known way in at least one elemental component, on progressing between one side region and another in a pair of opposite side regions.

The oxides can have an n value of 2, where at least one of the elemental components $A_1$, $A_2$ is a metal; an n value of 3, where at least two of the elemental components $A_1$, $A_2$ and $A_3$ are metals; an n value of 4, where at least three of the elemental components $A_1$, $A_2$, $A_3$ and $A_4$ are metals; and value of n greater or equal to 5, where at least three of the elemental components $A_i$ are metals.

$x_i$ associated with one of the elemental components $A_i$ can vary in a systematic way on progressing between one side region and another in a pair of opposite side regions, and $x_j$ associated with another elemental component $A_j$ can vary in a systematic was on progressing between one side region and another in another pair of opposite side regions.

$x_i$ associated with one of the elemental components $A_i$ can vary in a systematic way on progressing between one side region and another in a pair of opposite side regions, and y can vary in a systematic way on progressing between one side region and another in another pair of opposite side regions.

The oxides in the library can be multilayers or superlattices, and the structures or the oxides can vary systematically and in a known way in one or more of the following variables: (a) the total number of atomic layers forming the structures; (b) the chemical composition of the homogeneous (single-compound) oxides layers that appear in the multilayer oxide structure, (c) the thickness of each of the homogeneous (single-compound) oxide layers that appear in the multilayer oxide structure, and (d) the sequence of ordering of the homogeneous (single-compound) oxide layers that appear in the multilayer oxide structure.

For use in identifying oxides with high temperature superconductivity properties, the complex metal oxides may be formed as alternating copper oxide and metal or metal oxide monolayers.

For use in identifying oxides with desired ferroelectric properties, the oxides are formed as alternating titanium oxide, niobium oxide, tantalum oxide, or boron oxide, and metal or metal-oxide monolayers.

For use in identifying oxides with colossal magnetoresistant properties, the oxides are formed as alternating manganese oxide and metal or metal-oxide monolayers.

The library is formed by placing in a vacuum chamber containing a plurality of elemental sources with shutters, a substrate having a substrate surface bounded by two or more pairs of opposite side regions. The substrates defines in a plurality of surface regions at known position with respect to said side regions. Successive atomic layers are deposited on the substrate array regions in the presence of a gaseous source of ozone, oxygen plasma, $NO_2$, or some other suitable source of activated oxygen, while varying deposition conditions in a known and systematic way for at least one process variable on progressing between one side region and another in a pair of opposite side regions. The process variable may be: (i) the quantity of at least one elemental component deposited from one or more elemental sources; (ii) the sequence of deposition from the elemental sources, i.e. the source shuttering sequence; (iii) the temperature of the substrate regions; (iv) the partial pressure of ozone or atomic oxygen at the substrate regions, or (v) the thickness of barrier layers in multilayered structures.

Varying across the substrate array the process variable of the quantity of material deposited from an elemental source may be accomplished by placing between the source and the target, a sieve mask effective to produce a desired gradient of atomic flux through the mask, on progressing between one side region and another in a pair of opposite side regions of the substrate, or effective to produce a uniform atomic flux through the mask.

Varying the process variable of the quantity of material deposited from an elemental source may be accomplished, in addition or alternatively, by placing a movable shutter between the source and the target, at each of a plurality of selected positions.

Varying the temperature of the substrate regions may be accomplished by heating the substrate so as to produce a temperature gradient on progressing between one side region and another in a pair of opposite side regions of the substrate.

Varying the partial pressure of ozone or atomic oxygen at substrate regions may be accomplished by directing ozone from a source positioned at one side region of the substrate array, at a nearly grazing angle with respect to the substrate surface.

The deposition conditions for one or more of the process variables may be varied under the control of a program-controlled processor. Thus, a program-controlled processor may be used to control the placing of the sieve mask between the source and the target at each of the plurality of selected positions to produce the desired gradient of atomic flux through the mask, or the placing of the moveable shutter between the source and the target at each of the plurality of selected positions.

These and other objects and features of the invention will become more fully apparent when the following detailed description of the invention is read in conjunction with the accompanying drawings.

Brief Description of the Drawings

Fig. 1 shows a two-dimensional library of $A_xB_{1-x}C_yD_{1-y}O_3$ samples with x, y = 0, 0.2, 0.4, 0.6, 0.8, and 1.0 formed on a substrate;

Figs. 2A and 2B show a transmission sieve mask, illustrating movement of the mask between operative (Fig. 2A) and retracted (Fig. 2B) positions, and Fig. 2C is a side view of a frame adapted to reiceve the transmission mask when it is in its operative position;

Fig. 3 shows details of a source mask or sieve designed to generate right-to-left gradient of atomic flux, the deposition on the left side of a sample array being much higher than on the right side;

Fig. 4 illustrates moved positions of both lateral and vertical shadow masks positioned between an effusion source and a substrate array;

Fig. 5A fives the shadow-mask shuttering sequences for combinatorial growth of four distinct BiSrCaCuO oxides, and Fig. 5B shows the corresponding map of the phases formed;

Figs. 6A and 6B show front and side views, respectively, of a sample holder constructed to produce differential heating of the array regions in the sample;

Figs. 7A and /B show front and side views, respectively, of a sample holder constructed to produce differential ozone partial pressures across the array regions in the sample;

Fig. 8 shows a system for use in producing a combinatorial library of complex oxides by molecular beam epitaxy, in accordance with the invention;

Fig. 9 shows schematics of the main growth chamber of Oxxel COMBE system. It shows 16 water-cooled arms that house elemental metal sources, with gate valves. RHEED, TOF-ISARS, and LEEM are also displayed. Not shown here are the supporting vibration-insulation frame, turbo-molecular pumps (16 small ones on the arms and two large ones at the top), the sample and QCM manipulators, electrical, water, and gas connections; and

Fig. 10 is functional block diagram of a typical computer that may be used to control various aspects of the present invention.

Detailed Description of the Invention

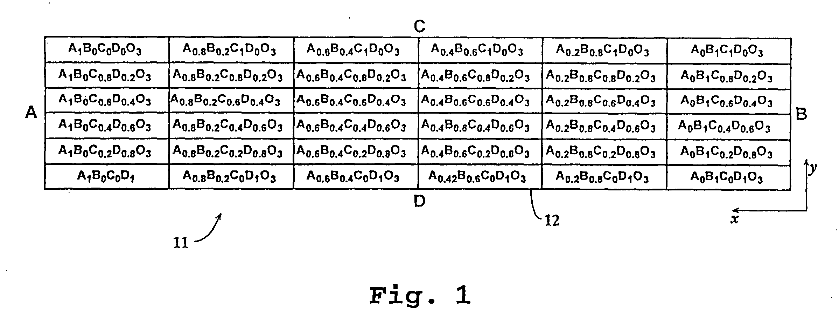

Fig. 1 schematically illustrates a rectangular substrate 11 having a surface 12 that is bounded by four side regions and defines 36 position-addressable surface regions. Formed on the surface regions, is a library of complex oxides identified generally by the formulae $A_xB_{1-x}C_yD_{1-y}O_3$, where each of A, B, C and D represent a metal and where x and y each vary from 0 to 1.0 in increments of 0.2 in the directions shown in the figure.

A. Key Parameters

The key parameters which influence the outcome of an ALL-MBE growth experiment are:

1. Stoichiometry, i.e., the chemical composition. This is determined by the quantity of each of the elements supplied and deposited onto the substrate.

2. Shuttering sequence. In case of ALL-MBE, the film growth is at least in part kinetically controlled, so the sequence in which the elements are supplied influences the film structure. This is most evident from the fact that one can grow superlattices and mulilayers which would otherwise never be formed in nature.

However; since the surface is at or close to the thermodynamic equilibrium, a major role is also played by the following thermodynamic parameters.

3. Substrate temperature, $T_s$. In general, this influences the phase diagram and provides some window in which a certain phase can be formed.

4. Oxygen partial pressure. In order to operate under high vacuum conditions, in ALL-MBE one generally does not use ordinary molecular oxygen ($O_2$) but rather some more reactive gas such as ozone ($O_3$) or other gaseous source of atomic oxygen such as oxygen plasma, $NO_2$ gas or other suitable source of activated oxygen. Ozone has much (as much as $10^4$ - $10^5$-times) more oxidation power than $O_2$, which depends somewhat on the substrate temperature. So, it is not enough to read the background gas pressure; one also has to know the $O_3$ to $O_2$ ratio. However, given the much higher reactivity of ozone, we can ignore $O_2$ and focus on the ozone partial pressure p in what follows.

5. Layer thickness. While the above parameters (1)-(4) are crucial in determining the results of a synthesis of any oxide film, single-phase or multi-layer, in the later case another important parameter that determines the device characteristics is the barrier thickness. For example, this is very much the case when fabricating tri-layer or sandwich-type SNS (superconductor/normal metal/superconductor) or SIS (superconductor/insulator/superconductor) junctions. The same is true for many physical properties of various superlattices, which depend on the thickness of the interchanging layers, and sometimes even in a rather unexpected way.

In order to maximize the effectiveness of the next-generation, combinatorial ALL-MBE machine, we have implemented the capability to vary all of the above parameters (1)-(5), one at a time or all at once, in a combinatorial way. This is described in what follows.

B. An Embodiment of Combinatorial Molecular Beam Epitaxy (COMBE):

A conventional ALL-MBE system is described, for example, in Ref. [1]. The following modifications and improvements make it possible to implement combinatorial search capability.

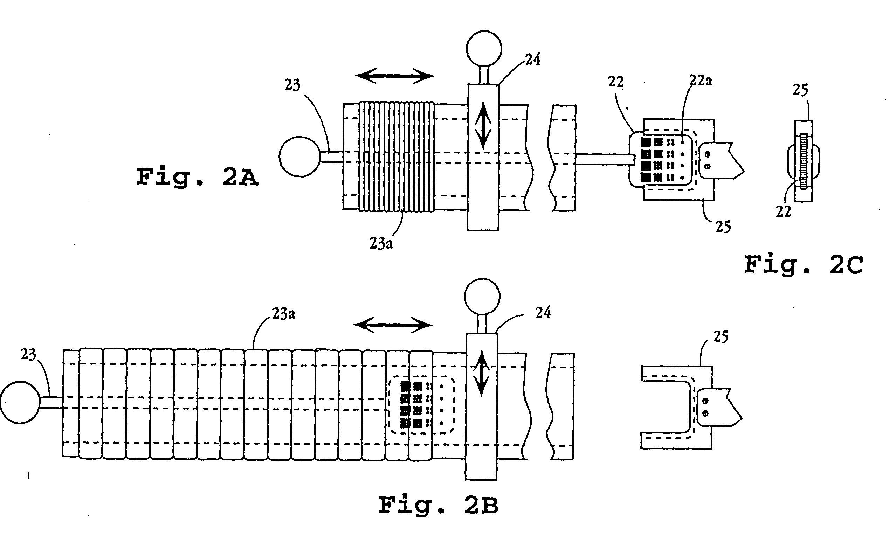

1. Sieve Masks. In front of each elemental metal source (Knudsen cell), one should add a transmission ('sieve') mask 22 - a simple piece of stainless steel (or other suitable material) with some holes 22a perforated in it (Figs. 2A and 2B).

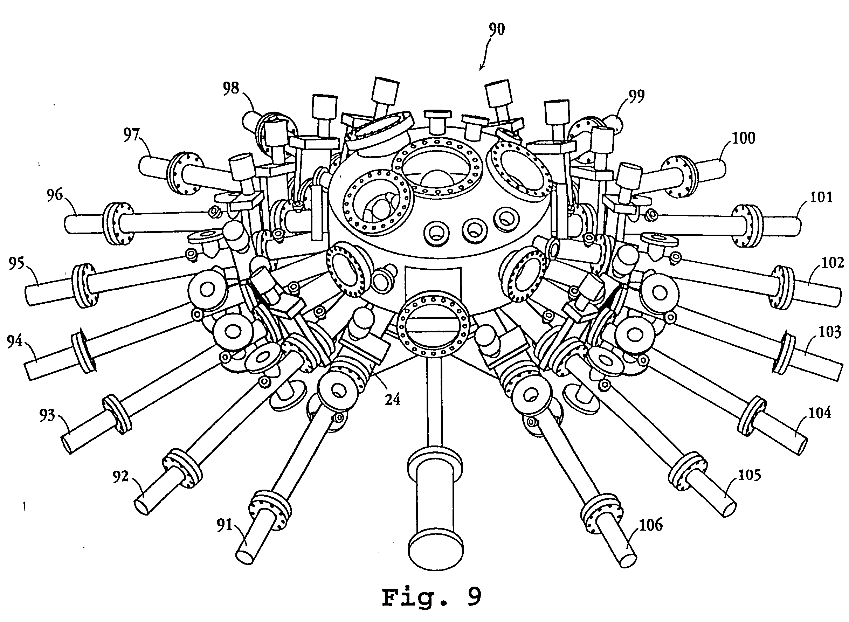

The mask 22 should preferable be attached to a linear-motion feed-through actuator (or a wobble stick) 23 with bellows 23a, so that it can be moved between an extended position, as shown in Fig. 2A, and a retracted position in a nipple, as shown in Fig. 2B. By means of a gate valve 24 moveable in the direction shown between an open and a closed position, the spool containing the mask 22 and the linear-motion actuator 23 can be disconnected from the main high-vacuum chamber (see Fig. 9) and opened. In this way, the mask 22 can be cleaned or replaced without having to vent the growth chamber (see Fig. 9). Attached to the source nipple (or to its water-cooling jacket) is a rigid frame 25 (see also Fig. 2C) which is adapted to receive the mask 22 which slides into the frame 25, thus ensuring that the mask 22 is always locked into the same position when extended.

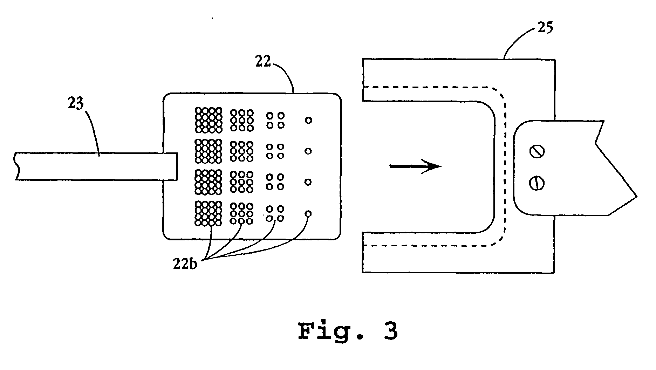

The gradient of the atomic flux across the substrate (or the array of substrates) 11 will depend on the distribution of holes 22a. For example, as illustrated in Fig. 3, imagine a square mask 22, divided into 4x4 equal fields 22b, and let each of these fields in the first left-hand-side column contain 4x4 holes, each one in the second column 3x3 holes, each in the third column 2x2 holes, and each in the last one a single hole. Clearly, the atomic beam transmitted by such a mask would have a vary steep gradient of flux going from highest on the left-hand side to the lowest on the right hand side.

While this example is oversimplified, it makes it clear that using such transmission masks 22 one can shape the atomic beams at will. One can go from essentially zero gradient, i.e., uniform deposition rate across the whole substrate area, to a very steep gradient, all the way to the maximum possible variation, i.e., going from 100 % at one side to 0 % at the opposite side.

Critical here is the size and distribution of the holes 22a, which should be selected in such a way to ensure the desired gradient of the atomic flux across the substrate (or the array of substrates). At the same time, it is important to maintain high transparency, so that one does not have to rise much the source temperature (and lose more source material) in order to maintain a reasonable deposition rate. This attachment enables one to control the composition gradient, separately for each element.

For better uniformity, one can use pairs of identical sources placed in opposition, i.e., with the atomic beam impinging at the same angle with respect to the substrates, but from the opposite sides. If the sources are placed on a circle centered at the axis normal to the substrate, this means that the pairs of complementary sources are placed at 180 degrees from one another. Using a simple transmission mask 22 placed on one of these two sources, we can control the gradient of the corresponding atomic flux across the substrate, from its maximal value (when one source is completely blocked and the other is open) to its minimal value (when both sources have the same intensity). Another way is to arrange that the two opposite sources of the same element have different atomic fluxes, e.g., by adjusting the temperature of each source. Yet another and the simplest way is to use different shuttering times on the two sources, i.e., to keep one of them open longer than the other, according to the desired gradient.

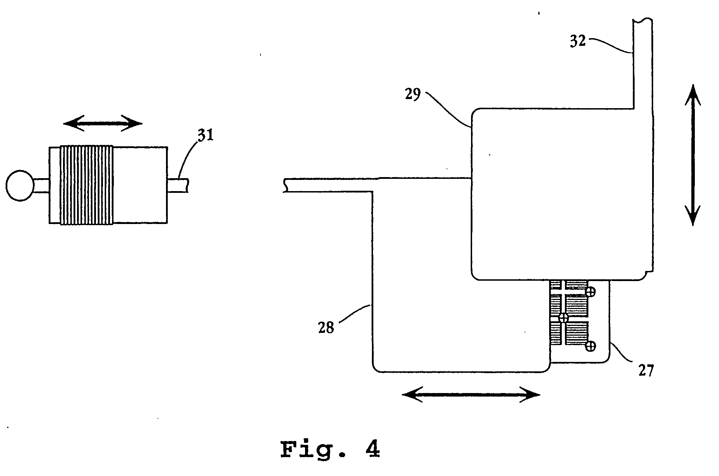

2. <u>Sample shadow masks.</u> Next, as shown in Fig. 4, in front of a substrate holder 27, one can insert two shutters 28 and 29, each on a linear motion feed-through actuator 31 and 32 respectively. The shutters 28 and 29 are oriented at 90° with respect to one another (say, one 29 vertical and one 28 horizontal as shown in the illustrated embodiment). These shutters 28 and 29 may be operated automatically, i.e., be computer-controlled, as a part of the programmed growth recipe. Each of the shutters 28 and 29 should allow for some discrete number of positions, from the fully open one in which there is no shadowing of the substrate to the fully closed one in which there is no deposition. In the simplest example given below, we assume that there is only one intermediate (half-closed) shutter position, where one half of the substrate array is in the shadow and the deposition is unobstructed at the other half. This arrangement provides for digital layer thickness control in multilayer structures, as requested in item (2) in the previous section A. For example, if one is investigating the optimum barrier thickness in tri-layer junctions, one can make a one-unit-cell thick barrier in the film on the first substrate, a two-unit-cells thick barrier in the second, a three-unit-cells thick barrier in the next, and so on.

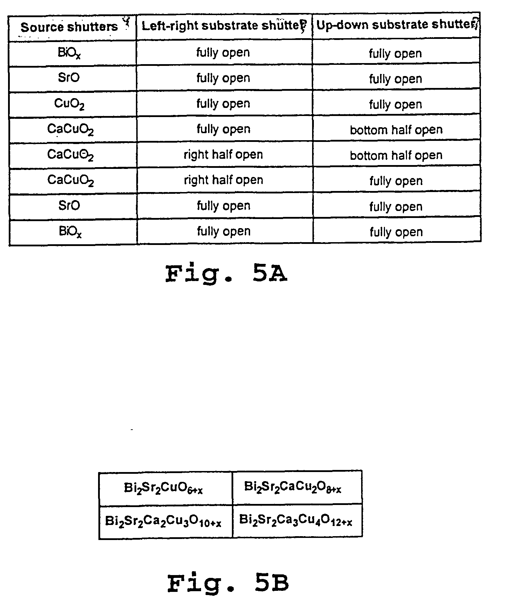

In combination with the source shutters which are already commonly present in ALL-MBE systems, this also allows one to effectively *vary the shuttering sequence* for different samples in the array. This is explained in the following simple example. Let us assume that the shuttering sequence of the main source shutters is programmed in such a way to deposit single-phase $Bi_2Sr_2Ca_3Cu_4O_{12+x}$. The auxiliary substrate-shadowing shutters 28 and 29 can be used to selectively block some substrates for a part of the layering sequence, and on these substrates different phases will be deposited, as shown in Fig. 5A. In our case, these will be $Bi_2Sr_2Ca_2Cu_3O_{10+x}$ (with typical $T_c = 110$ K), $Bi_2Sr_2CaCu_2O_{8+x}$ ($T_c = 85$ K), $Bi_2Sr_2Cu_2O_{8+x}$ ($T_c = 85$ K), $Bi_2Sr_2CuO_{6+x}$ ($T_c = 10$ K), and $Bi_2Sr_2Ca_3Cu_4O_{12+x}$, as shown in Fig. 5B.

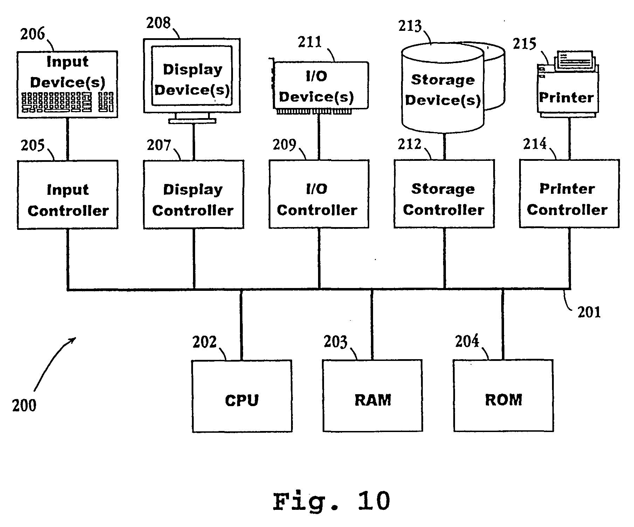

As will be described in more detail with reference to Fig. 10, the control of source shutters, sieve mask 22, or sample shadow shutters 28 and 29 may be implemented by a suitable digital computer operating under the control of a program of instructions (i.e., software) written in accordance with the teachings herein, or, alternatively, may be controlled using a functionally equivalent hardware module constructed using known discrete components, application specific integrated circuits (ASICs) or the like.

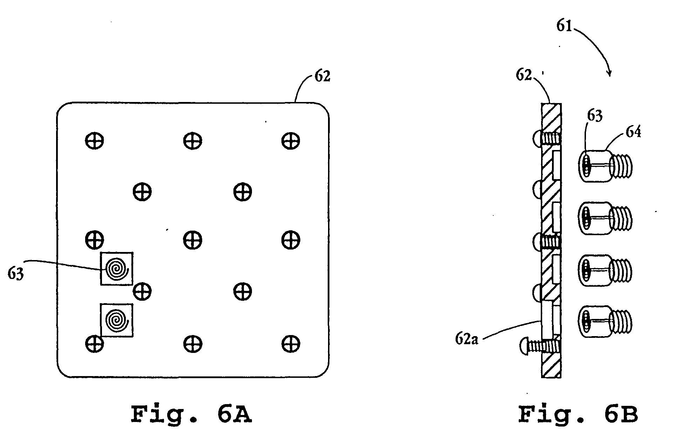

3. <u>Multi-filament heater.</u> It is possible to insert a heater system 61 similar to the currently employed ones, but having several heater filaments, each with its own individual current control. (Instead of bare filaments, it is possible also to use UHV-compatible heater lamps, which are also commercially available; the principle remains the same.) For example, consider a substrate holder 62 having holes 62a for 4x4 1cm$^2$ substrates, with the back side of substrates coated with a metal (e.g., with a Ti-Pt-Au multi-layer) and exposed to radiation, from an array of 4x4 individually controlled heater filaments 63, bare or in quartz lamps 64 (Fig. 6). The temperature of each substrate in the matrix can be read using an optical pyrometer.

In this way, one could easily achieve either a uniform temperature across the substrate matrix, or if so desired, have a large temperature gradient, say with 100° difference in $T_s$ from one side to another.

Instead of this matrix of small substrates, the same heater system 61 could easily accommodate one circular 3" (or even larger) wafer.

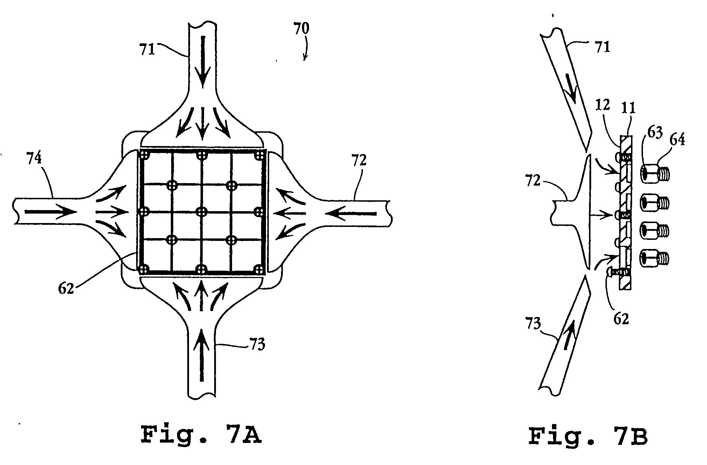

4. Multi-nozzle ozone delivery system. The last remaining component needed for a complete control over our desired set of variable parameters for combinatorial search, is the oxidation power. A control of this gradient can also be implemented by using a multiple-nozzle system 70 for supplying ozone to the substrate 11. For example, one can have four nozzles 71, 72, 73 and 74, at a steep angle with respect to the substrated holder 62 and substrate 11, placed one at every 90 degrees around the substrate, and each supplied with a needle valve and a flow meter (Fig. 7). In this way, one can select between the most uniform configuration, where ozone is coming trough all four nozzles 71, 72, 73 and 74, and the most asymmetric arrangement, with only one nozzle active. Given that the surface 12 of the substrate 11 to which the ozone beam is directed is rather hot, typically around 700°C, one expects that there will be substantial decomposition of ozone and recombination into (much less reactive) molecular oxygen, depending on the amount of differential pumping, the pumping speed of the MBE system in question, and the size and position of the nozzles. So it is possible to achieve a substantial gradient of the partial pressure of ozone across the substrate matrix, say a factor of 5-10 difference between the sites experiencing the highest and lowest values of p.

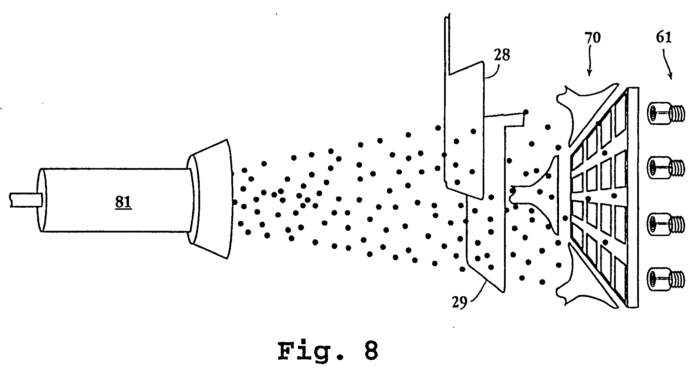

Taken together, the four devices (sieve or transmission mask 22, shadow masks or shutters 28 and 29, multi-filament heater 61, and multi-nozzle ozone delivery system 70) described above allow one to optimize the film composition, the shuttering sequence, the layer thickness, the substrate temperature $T_s$ and the ozone partial pressure p, for a given targeted single-phase film or hetero-structure, using powerful parallel, combinatorial searching strategy. These four devices together with an elemental metal source 81 are shown in Fig. 8.

C. Mathematical aspects of implementation of combinatorial MBE

While it is apparent that the ideas expounded above are valid qualitatively, for actual implementation in practice it is necessary to first optimize the geometry of the orifices (i.e., holes 22a) in sieve masks 22 as well as that of the ozone delivery system 70. This requires numerical simulation of atomic-beam flux gradients. In the molecular flow regime, if the orifice can be considered a point source, the gas flow can be described using the Knudsen formula:

$$I = (I_0/r^2)\cos\Theta\cos(\Theta+\phi) \qquad (1)$$

Here, $I$ is the atom impingement rate (to which the deposition rate is proportional if $T_s$ is constant across the substrate area), $\phi$ is the angle between the normal to the substrate and the normal to the surface containing the pinhole, $\Theta$ is the angle between the direction at which the deposition rate is calculated, and the normal to the surface containing the pinhole, and r is the distance from the pinhole to the point at the substrate surface at which the deposition rate is calculated. [9] Note that this approximation is valid when the mean free path $\lambda$ of the atoms or molecules is large compared to the orifice diameter $d$, and in the far field where the distance R from the pinhole to the center of the substrate is also large compared to $d$.

The mathematical tasks are as follows. Let the geometry of the MBE system and the operating pressure be known; this defines R, $\phi$, and the range of values of $r$ and $\Theta$ that are of interest, as well as the molecular mean free path $\lambda$. Let the mask under study contain N pinholes, of diameter $d_P$ ..., $d_N$, positioned at $(x_1, y_1)$, $(x_2, y_2)$,...., $(x_N, y_N)$ on the mask. It is straightforward to calculate the distribution of the deposition rates across the substrate array area, for any given mask. However, we are actually interested in the inverse optimization problem: for given deposition-rate gradient distribution, we have to find the optimal mask design that approximates this distribution most closely, and also maximizes the transmission through the mask. Iterative numerical simulations can accomplish this. As pointed out above, for better uniformity, one can use pairs of identical sources placed in opposition, i.e., with the atomic beam impinging at the same angle with respect to the substrates, but from the opposite sides. Using a simple transmission mask placed on one of these two sources, we can control the gradient of the corresponding atomic flux across the substrate, from its maximal value (when one source is completely blocked and the other open) to its minimal value (when both sources have the same intensity). Analytical inversion results, whenever available, can be used to accelerate these numerical simulations. The optimization of the number, shape, and position of ozone nozzles can be done analogously. In particular, this should take into account collimation of the sources and the finite thickness of the sieve masks. A more advanced treatment should go beyond the simple Knudsen formula (1), and include higher-order corrections and departures from the ideal gas-flow regime.

### D. The Oxxel Combinatorial Molecular Beam Epitaxy (COMBE) Apparatus

As one preferred embodiment of the apparatus of the present invention, we have implemented, at Oxxel GmbH Laboratory in Bremen, a Combinatorial Molecular Beam Epitaxy (COMBE) system, which is illustrated in Fig. 9 and described in this section.

A multi-chamber ultra-high vacuum (UHV) system, with the base pressure in the $10^{-11}$ Torr range, is placed in two neighboring laboratories, connected through the wall with the transport chamber, which also serves as the wafer storage chamber. One of theses laboratories is a clean-room area, which houses a substrate (un)loading chamber, and a processing chamber in which the key micro-fabrication steps (metallization, insulation, surface cleaning and oxidation, and ion-milling) can be performed without breaking the vacuum. The second laboratory houses the main growth chamber, an annealing chamber, and the second wafer introduction chamber.

As shown in Fig. 9, the main growth chamber 90 is provided with 16 arms 91-106, which house the metal sources 81. The sources 81 are easily interchangeable; the system is modular. Each arm 91-106 is provided with a gate valve 24 and with autonomous pumping by means of a dedicated small (70 1/s) turbomolecular pump and roughing line. It is thus possible to valve each arm off, and the recharge, service, interchange, or out-gas each source, without having to break the vacuum and interrupt functioning of the main chamber 90. The metal sources 81 (see Fig. 8) are either thermal effusion cells (low-temperature, high-temperature, our double-filament cells), or rod-fed electron-beam sources; they allow access to most of the elemental metals in the periodic system.

The sources 81 are aimed at the substrate 11 (see Fig. 1) at about 20°, which allows for a large compositional spread (gradient) across the substrate array area. Each source 81 is provided with a liner-motion feed-through actuator 23 and attached sieve mask 22, and is further provided with computer-controlled pneumatic linear motion feed-through actuators 31 and 32, each of which can carry a shadow mask 28 and 29 respectively, as described in section B above. Next, each arm 91-106 contains four optical ports, two next to the sources and two behind the shutter, allowing for accurate on-line (real-time) monitoring of the atomic flux by atomic absorption spectroscopy [10], on either side of the shutter.

The main chamber 90 itself is pumped by two large (1,000 1/s) turbo-molecular pumps (not shown in Fig. 9) with magnetic bearings, mounted on special spools for vibration insulation. To further minimize the vibrations of the sample with respect to the electron microscope (see below), the entire chamber 90 is placed on a passive (pneumatically damped) vibration insulation frame; a sample vibration damper is also provided.

The chamber 90 is further provided with a sample manipulator, which allows for full sample rotation and translation. The manipulator carries a water-cooled sample heater system 61, which contains 4 UHV-compatible quartz-lamp heaters, arranged in a linear array (see Fig. 6B). Each lamp 64 is controlled separately, which allows one to maintain a temperature gradient along one direction, across the substrate array, or to achieve uniform heating of the whole array. The same sample manipulator also carries a set of 4 water-cooled nozzles 70 (see Fig. 7) for delivery of ozone or other gas source of activated oxygen. The nozzles 71-74 move together with the substrate holder 27 (see Fig. 4) in such a way that they maintain a fixed position with respect to the sample array while the latter is rotated or translated. Next, the chamber 90 is provided with a set of state-of-the-art analytical tools. These include a quartz-crystal rate monitor (QCM) on a separate motorized manipulation that allows for full and computer-controlled, x, y, z motion, so that deposition rates can be mapped accurately, for each source, at an arbitrary position on the substrate array. A reflection high-energy electron (RHEED) system is provided as well, with the capability to switch fast (i.e., to scan) from one to another substrate position in the 16-sample array, and to display the RHEED patterns from each of the 16 films simultaneously, using multiple screens. Both innovations have been implemented specifically to enhance the capabilities of this apparatus for combinatorial synthesis and search.

The chamber 90 is further provided with a Low-Energy-Electron Microscope, LEEM, allowing for real-time (video-rate) imaging, at nanometer-scale resolution, of the surface of the growing film [11]. It enables one to observe, study, and quantify the film nucleation and growth, and identify the growth mechanism(s) such as island nucleation or step-flow growth [12]. The same instrument can also function as a Low-Energy Electron Diffraction (LEED) system, or as a Photo-Excited Electron Microscope (PEEM); for the latter, an ultraviolet light source is also provided. Finally, a Time-of-Flight Ion Scattering and Recoil Spectroscopy (TOF-ISARS) system is provided, with multiple detectors and analyzers at several angles, including the Mass-Spectroscopy of Recoiled Ions (MSRI) analyzer [13]. This is a very accurate surface analysis tool that provides quantitative information on the chemical composition of the surface mono-layer, also in real time during the film growth.

Overall, the Oxxel COMBE system has been optimized for a high-throughput combinatorial search through an enormous phase space, aided further by state-of-the-art analytical tools such as LEEM and TOF-ISARS, as well as multiple-readout RHEED and scanning QCM systems, none of which has been integrated with an oxide MBE system before.

As previously noted and as will be appreciated by one skilled in the art, various aspects of the present invention (i.e., control of the source shutters, sieve masks 22, shadow mask shutters 28 and 29, or mapping source deposition rate) may be carried out using a processor-controlled device, such as a digital computer. Fig. 10 is a functional block diagram of a typical computer system 200 that may be used to implement one or more of these aspects of the invention. As shown, this computer system 200 includes a bus 201 that interconnects a central processing unit (CPU) 202 which represents processing circuitry such as a microprocessor, a system memory comprised of various memory components such as random-access memory (RAM) 203 and read-only-memory (ROM) 204, and a plurality of device interfaces, i.e., controllers). Input controller 205 represents interface circuitry that connects to one or more input devices 206 such as a keyboard, mouse, track ball or the like. Display controller 207 represents interface circuitry that connects to one or more display devices 208 such as a computer monitor. I/O controller 209 represents interface circuitry that connects to one or more I/O devices 211 such as a modem or a network connection. Storage controller 212 represents interface circuitry that connects to one or more storage devices 213 such as a magnetic disk or tape drive, optical disk drive, solid-state storage device, or the like. Printer controller 214 represents interface circuitry that connects to one or more printer devices 215 such as a laser, ink-jet printer or plotter. No particular type of computer system is critical to practice the computer-controllable aspects of the present invention. Any suitable computer system or processor-controlled device may be used.

In the embodiment, CPU 202 controls the operation of shutters 28 and 29 by executing a program of instructions residing in RAM that may be fetched from ROM 204, storage device 213 or obtained from a network server or other source through I/O device 211. More broadly, the program of instructions (i.e., software) may be conveyed by any medium that is readable by CPU 202 or other suitable program-controlled processor. Such media include various magnetic media such as discs or tapes, various optical media such as compact discs, as well as various communication paths throughout the electromagnetic spectrum including baseband or broadband signals and a carrier wave encoded to transmit the program of instructions.

Alternatively, control of shutters 28 and 29 may be implemented with functionally equivalent hardware using discrete components, application specific integrated circuits (ASICs), or the like. Such hardware may be physically integrated with the CPU 202 or may be a separate element. Where the hardware is a separate element, it may be embodied in the computer 202 itself or on a computer card that can be inserted into an available card slot in the computer 200.

Thus, the term "program-controlled processor" as used herein is intended to cover both a processor operating under the control of appropriate software and a device having the appropriate programming hardwired therein.

In addition to the shutters 28 and 29, various other aspects of the library synthesis method may also be computer controlled, including control of the source shutters, the sieve masks 22, or the source deposition rates in accordance with the teachings herein. Given these teachings, one skilled in the art would be able to write (or have written) specific code or to design (or have designed) functionally equivalent hardware to implement the control of these features.

It should be apparent to someone skilled in the art that a number of obvious changes and modifications could be made to a system like this one, such as changing the number of sources, or the number of heater filaments, or the number and shape of the ozone nozzles, etc.; however, this would not represent essential modifications nor improvements over the present invention.

**Claims**

1. Apparatus for combinatorial molecular beam epitaxy comprising:

   - a vacuum chamber,

   - a substrate holder (27 or 62) for holding a substrate (11) inside said vacuum chamber having a substrate surface bounded by two or more pairs of opposite side regions and defining a plurality of surface regions at known position with respect to said side regions,

   - a gaseous source of oxygen atoms and

   - a plurality of elemental metal sources (81) with source shutters contained in said vacuum chamber,

   further comprising at least one device being selected from the group consisting of:

   - a heater system (61) for heating said substrate (11) so as to produce a temperature gradient on progressing between one side region and another in a pair of opposite side regions of said substrate (11),

   - a system for applying said oxygen atoms to said substrate (11) to achieve a gradient of the partial pressure of said source of oxygen atoms and the substrate surface regions,

   - a sieve mask (22) in front of each elemental metal source (81) effective to produce a desired gradient of atomic flux through said sieve mask (22) on progressing between one side region and another in a pair of opposite side regions of the substrate (11) or effective to produce a uniform atomic flux through said sieve mask (22) and

- a movable substrate-shadowing shutter (28, 29) placed between each elemental metal source (81) and the target placeable at a plurality of selected positions.

2. Apparatus according to claim 1, wherein a program-controlled processor is provided for controlling at least one of said devices.

3. Apparatus according to claim 2, wherein said program-controlled processor functions to control said source shutters and/or the elemental metal source deposition rates.

4. Apparatus according to claim 2 or 3, wherein said program-controlled processor is a digital computer.

5. Apparatus according to any one of the preceding claims, wherein said vacuum chamber is part of a multi-chamber ultra-high vacuum (UHV) system.

6. Apparatus according to claim 5, wherein said multi-chamber ultra-high vacuum system is placed in two neighboring laboratories connected through the wall with a transport chamber, which also serves as a wafer storage chamber, one of said laboratories being a clean-room area, which houses a substrate (un)loading chamber and a processing chamber and the second laboratory housing said vacuum chamber serving as a main growth chamber (90), an annealing chamber and a second wafer introduction chamber.

7. Apparatus according to any one of the preceding claims, wherein said main growth chamber (90) is provided with sixteen water-cooled arms (91-106) which house said elemental metal sources (81) and are provided with a gate valve (24) and with a small turbo-molecular pump and roughing line.

8. Apparatus according to claim 7, wherein each arm (91-106) contains four optical ports, two next to the elemental metal source (81) and two behind said source shutter.

9. Apparatus according to any one of the precedings claims, wherein two large turbo-molecular pumps with magnetic bearings mounted on spools for vibration insulation are provided.

10. Apparatus according to any one of the preceding claims, wherein said main growth chamber (90) is placed on a passive vibration insulation frame.

11. Apparatus according to any one of the preceding claims, wherein a sample vibration damper is provided.

12. Apparatus according to any one of the preceding claims, wherein said main growth chamber (90) is provided with a sample manipulator which allows for full sample rotation and translation.

13. Apparatus according to any one of the preceding claims, wherein said main growth chamber (90) is provided with at least one analytical tool being selected from the group consisting of:

- a quartz-crystal rate monitor (QCM),

- a reflection high-energy electron (RHEED) system,

- a Low-Energy-Electron Microscope (LEEM) system,

- a Low-Energy-Electron Diffraction (LEED) system,

- a Photo-Excited Electron Microscope (PEEM) and

- a Time-of-Flight Ion Scattering and Recoil Spectroscopy (TOF-ISARS) system with multiple detectors and analyzers at several angles, including a Mass-Spectroscopy of Recoiled Ions (MSRI) analyzer.

14. Apparatus according to any one of the preceding claims, wherein said gaseous source of oxygen atoms is a gaseous source of ozone, oxygen plasma, $NO_2$ or some other suitable source of activated oxygen.

15. Apparatus according to any one of the preceding claims, wherein said elemental metal sources (81) are thermal effusion cells.

16. Apparatus according to any one of claims 1 to 14, wherein said elemental metal sources (81) are rod-fed electron-beam sources.

17. Apparatus according to any one of the preceding claims, wherein each elemental metal source (81) is provided with a linear-motion feed-through actuator (23) and attached sieve mask (22) and is further provided with computer-controlled pneumatic linear motion feed-through actuators (31 and 32) on which said substrate-shadowing shutters (28, 29) are.

**18.** Apparatus according to any one of the preceding claims, wherein pairs of identical elemental metal sources (81) are placed in opposition.

**19.** Apparatus according to any one of claims 2 to 18, wherein the shuttering sequence of said source shutters is controlled by said program-controlled processor.

**20.** Apparatus according to any one of the preceding claims, wherein said heater system (61) has several heater filaments (63) bare or in quartz lamps (64), each with its own individual current control.

**21.** Apparatus according to any one of the claims 1 to 19, wherein said heater system (61) has several UHV-compatible heater lamps.

**22.** Apparatus according to claim 20 or 21, wherein said substrate holder (62) has holes (62a) for substrates, with the back side of said substrates coated with a metal and exposed to radiation from said heater system (61).

**23.** Apparatus according to any one of the preceding claims, wherein an optical pyrometer is provided.

**24.** Apparatus according to any one of the preceding claims, wherein said system for supplying said oxygen atoms is a multiple-nozzle system (70).

**25.** Apparatus according to claim 24, wherein said multiple-nozzle system (70) has four nozzles (71, 72, 73 and 73) at a steep angle with respect to said substrate holder (62) and said substrate (11), placed one at every 90 degrees around said substrate (11) and each supplied with a needle valve and a flow meter.

**26.** Apparatus according to any one of the proceeding claims, wherein each sieve mask (22) is a piece of stainless steel with some holes (22a) perforated in it.

EP 1 161 986 A2

C

| $A_1B_0C_0D_0O_3$ | $A_{0.8}B_{0.2}C_1D_0O_3$ | $A_{0.6}B_{0.4}C_1D_0O_3$ | $A_{0.4}B_{0.6}C_1D_0O_3$ | $A_{0.2}B_{0.8}C_1D_0O_3$ | $A_0B_1C_1D_0O_3$ |
|---|---|---|---|---|---|
| $A_1B_0C_{0.8}D_{0.2}O_3$ | $A_{0.8}B_{0.2}C_{0.8}D_{0.2}O_3$ | $A_{0.6}B_{0.4}C_{0.8}D_{0.2}O_3$ | $A_{0.4}B_{0.6}C_{0.8}D_{0.2}O_3$ | $A_{0.2}B_{0.8}C_{0.8}D_{0.2}O_3$ | $A_0B_1C_{0.8}D_{0.2}O_3$ |
| $A_1B_0C_{0.6}D_{0.4}O_3$ | $A_{0.8}B_{0.2}C_{0.6}D_{0.4}O_3$ | $A_{0.6}B_{0.4}C_{0.6}D_{0.4}O_3$ | $A_{0.4}B_{0.6}C_{0.6}D_{0.4}O_3$ | $A_{0.2}B_{0.8}C_{0.6}D_{0.4}O_3$ | $A_0B_1C_{0.6}D_{0.4}O_3$ |
| $A_1B_0C_{0.4}D_{0.6}O_3$ | $A_{0.8}B_{0.2}C_{0.4}D_{0.6}O_3$ | $A_{0.6}B_{0.4}C_{0.4}D_{0.6}O_3$ | $A_{0.4}B_{0.6}C_{0.4}D_{0.6}O_3$ | $A_{0.2}B_{0.8}C_{0.4}D_{0.6}O_3$ | $A_0B_1C_{0.4}D_{0.6}O_3$ |
| $A_1B_0C_{0.2}D_{0.8}O_3$ | $A_{0.8}B_{0.2}C_{0.2}D_{0.8}O_3$ | $A_{0.6}B_{0.4}C_{0.2}D_{0.8}O_3$ | $A_{0.4}B_{0.6}C_{0.2}D_{0.8}O_3$ | $A_{0.2}B_{0.8}C_{0.2}D_{0.8}O_3$ | $A_0B_1C_{0.2}D_{0.8}O_3$ |
| $A_1B_0C_0D_1$ | $A_{0.8}B_{0.2}C_0D_1O_3$ | $A_{0.6}B_{0.4}C_0D_1O_3$ | $A_{0.42}B_{0.6}C_0D_1O_3$ | $A_{0.2}B_{0.8}C_0D_1O_3$ | $A_0B_1C_0D_1O_3$ |

A                                                                                                                          B

D

11          12

$y$ $x$

Fig. 1

Fig. 2A

Fig. 2B

Fig. 2C

Fig. 3

EP 1 161 986 A2

**Fig. 4**

| Source shutters | Left-right substrate shutter | Up-down substrate shutter |
|---|---|---|
| $BiO_x$ | fully open | fully open |
| SrO | fully open | fully open |
| $CuO_2$ | fully open | fully open |
| $CaCuO_2$ | fully open | bottom half open |
| $CaCuO_2$ | right half open | bottom half open |
| $CaCuO_2$ | right half open | fully open |
| SrO | fully open | fully open |
| $BiO_x$ | fully open | fully open |

# Fig. 5A

| | |
|---|---|
| $Bi_2Sr_2CuO_{6+x}$ | $Bi_2Sr_2CaCu_2O_{8+x}$ |
| $Bi_2Sr_2Ca_2Cu_3O_{10+x}$ | $Bi_2Sr_2Ca_3Cu_4O_{12+x}$ |

# Fig. 5B

Fig. 6B

Fig. 6A

Fig. 7B

Fig. 7A

Fig. 8

Fig. 9

Fig. 10

EP 1 161 986 A2